# EUROPÄISCHE PATENTSCHRIFT

(11) **EP 2 283 275 B1**
(45) Veröffentlichungstag und Bekanntmachung des Hinweises auf die Patenterteilung: **09.01.2019**
(21) Anmeldenummer: 09757419.8
(22) Anmeldetag: 27.05.2009
(51) Int. Cl.: F21K 99/00, H01L 25/075, H05K 1/02, H01L 33/62, H01L 33/64

(54) **BELEUCHTUNGSANORDNUNG MIT LED-ARRAY**
LED LIGHTING ARRAY
DISPOSITIF D'ÉCLAIRAGE À RÉSEAU DE DEL

(30) Priorität: 03.06.2008 DE 102008026628
(43) Veröffentlichungstag der Anmeldung: 16.02.2011
(73) Patentinhaber: Siemens Aktiengesellschaft, 80333 München (DE)
(72) Erfinder: GERHARD, Detlef, 81829 München (DE)
(86) Internationale Anmeldenummer: PCT/EP2009/056416
(87) Internationale Veröffentlichungsnummer: WO 2009/147036

(56) Entgegenhaltungen:
- EP-A- 1 367 870
- EP-A- 1 788 677
- WO-A1-2009/138374
- JP-A- 9 008 222
- JP-A- 2008 071 844
- US-A1- 2003 193 055
- US-A1- 2004 114 648
- US-A1- 2004 208 210
- US-A1- 2006 245 188
- US-A1- 2008 019 142

## Beschreibung

Die Erfindung betrifft die Verteilung von LED-Chips auf einer Leiterplatte zur Erzeugung von optimal gebündelten LED Beleuchtungen.

Beim Aufbau von Hochleistungs-Beleuchtungssystemen auf LED-Basis (Licht emittierende Dioden) werden einerseits leistungsstarke LED-Chips verwendet und andererseits wird versucht durch eine dichte Packung der LED-Chips möglicht viel Licht auf kleiner Fläche zu erzeugen. Bei solchen auf LED-Chips basierenden Beleuchtungen spielt die Verteilung der LED-Chips auf einer Platine eine große Rolle bezüglich Ansteuerung und optischem Wirkungsgrad. Bisher sind die meisten bekannten Systeme so ausgeführt, dass sich die LED-Chips eines LED-Arrays/LED-Anordnung auf der gleichen Platinenlage befinden oder auf einer einzigen Ebene, die über x- und y-Achse eines kartesischen Koordinatensystems aufgespannt ist, also auf gleicher Höhe, d.h. gleichem z-Abstand, positioniert sind.

Bisher wurden LED-Chips somit im Wesentlichen auf einlagigen Platinen oder auf einer Ebene einer Multi-Layer-Platine (Mehrlagenleiterplatte) aufgebracht. Eine solche Anordnung ist beispielsweise aus der US 2004/0233671 A1 bekannt. Auch können die LEDs auf einer flexiblen Leiterplatte montiert werden, um einen Einbau als stufenförmige Kaskade beispielsweise in einem Kfz-Scheinwerfer zu ermöglichen, wie dies die DE 101 60 938 A1 beschreibt. Eine weitere Möglichkeit besteht in der Vergrößerung der LED-Chips selbst. Größere Chips bedeuten jedoch auch vergrößertes Risiko bei der Produktion selbst, so dass die Ausbeute sinken kann.

Werden mehrere LED-Chips auf einer Lage aufgebracht, so muss entweder irgendein Bonddraht über die anderen LED-Chips hinweg geführt werden oder es muss genügend Abstand zwischen den Chips eingehalten werden, so dass der Bonddraht zwischen den LED-Chips verlegt werden kann. Dies ist z. B. in der US 2004/0208210 A1 gezeigt.

Die EP 1 788 677 A1 beschreibt eine Lichtquelle mit mehreren Laserdioden, die jeweils mit einem nichtleitenden Hilfsträger und einer darauf aufgebrachten Metallisierung eine Untereinheit bilden, wobei diese Untereinheiten gestapelt oder treppenförmig angeordnet sein können.

Aus der WO 2009/138374 A1, die Stand der Technik gemäß Artikel 54(3) EPÜ darstellt, ist bekannt, dass eine LED-Beleuchtungsanordnung auch auf einer Mehrlagenleiterplatte aufgebaut werden kann. Zur Bildung eines Flächenstrahlers werden die LED-Chips in einem dreidimensionalen Aufbau auf mehreren stufenförmig ausgebildeten Metalllagen der Mehrlagenleiterplatte positioniert und mit den Metalllagen elektrisch kontaktiert, so dass die LED-Chips gruppenweise in Reihe geschaltet sind, was beispielsweise über Bonddrähte erfolgen kann.

Der Erfindung liegt somit die Aufgabe zugrunde, eine für leistungsstarke LED-Beleuchtungen effektive elektrische Verschaltung bereitzustellen, mittels der eine optimale laterale LED-Anordnung bei wahlweise ausführbarer Schaltung mit Wärmeableitung möglich ist.

Die Lösung dieser Aufgabe geschieht durch die Merkmalskombination entsprechend Anspruch 1. Vorteilhafte Ausgestaltungen können den Unteransprüchen entnommen werden.

Der Erfindung liegt die Erkenntnis zugrunde, dass mit LED-Chips auf Multi-Layer-Platinen/Mehrlagenleiterplatten eine beliebige Verschaltung unabhängig von deren lateraler Position auf der Multi-Layer-Platine möglich ist.

Durch die stufenförmige Anordnung der LED-Chips über mehrere Ebenen einer Multilayer-Platine verteilt sich die Wärme der LED-Chips auf mehrere Lagen. Hierbei befindet sich mindestens ein LED-Chip des Chip-Arrays auf einer Metalllage der Multilayer-Platine. Hierbei sind die LED-Chips beispielsweise mit einem leitenden Kleber mit der Metalllage verbunden. Die Art der Verbindung spielt eine untergeordnete Rolle, solange über die Verbindung von Chiprückseite zur Metalllage eine elektrische Verbindung herstellbar ist.

Die Wärmeleitung innerhalb der Multilayer-Platine geschieht erfindungsgemäß über VIAs/Durchgänge, welche die Wärme von den einzelnen elektrisch leitenden Lagen auf eine außen aufgebrachte Kupferlage abführen.

Im Folgenden werden anhand schematischer Figuren die Erfindung nicht einschränkende Ausgestaltungen beschrieben:
- Figur 1: zeigt den prinzipiellen Aufbau eines Flächenstrahlers basierend auf LED-Chips, in der Aufsicht,
- Figur 2: zeigt den prinzipiellen Aufbau eines Flächenstrahlers mit LED-Chips in der Seitenansicht,
- Figur 3: zeigt den prinzipiellen Aufbau eines Flächenstrahlers basierend auf LED-Chips in der Seitenansicht.

Im Folgenden werden nochmals verschiedene Merkmale angeführt, die die Erfindung oder Ausgestaltungen der Erfindung betreffen.

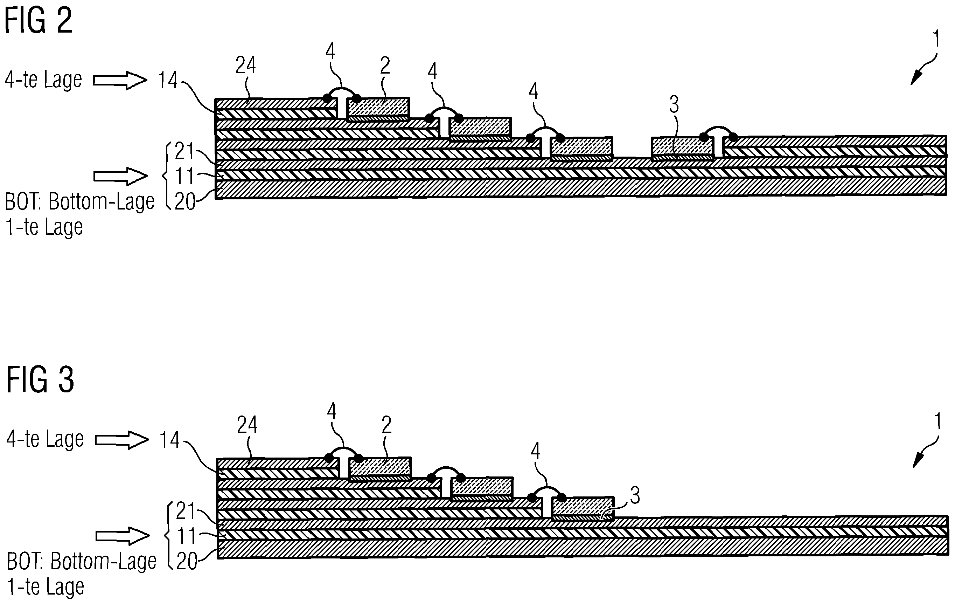

Es wird der Umstand genutzt, dass für die Verteilung der LED-Chips mehrere Lagen einer Multilayer-Platine verwendbar sind. Hierdurch entsteht ein 3-dimensionaler Aufbau, siehe auch Figuren 2 und 3.

Mindestens ein elektrischer Anschluss eines LED-Chips ist mit der darüber liegenden leitenden Lage elektrisch verbunden.

Mindestens ein elektrischer Anschluss des LED-Chips ist mit der leitenden Lage verbunden, auf der der Chip aufgebracht ist.

Die Leiterbahnen LB (n,i), mit n als Anzahl der Lagen und i als Lagenummer auf einer Ebene, der elektrisch leitenden Lagen (n) sind derart geführt, dass hierdurch mehrere LED-Chips elektrisch in Reihe geschaltet sind. Hierbei ist ein LED-Chip auf einer elektrisch leitenden Lage positioniert und elektrisch mit einem LED-Chip, welcher auf einer anderen elektrisch leitenden Lage positioniert ist, verbunden, wobei diese oberhalb oder unterhalb liegt, was bei mehrfacher Ausbildung zu jeweils benachbarten Bauteilen einer Serienschaltung entspricht.

Die elektrisch leitenden Metalllagen bestehen aus mehreren Leiterbahnen LB(n,i), welche durch Isolierlagen 11, 12, ... voneinander getrennt sind. Die die LED-Chips werden auf mehrere, mindestens aber einen, seriellen elektrischen Zweig gelegt. Prinzipiell können Serien- und oder Parallelschaltungen für die LEDs ausgebildet werden.

Es gibt bei der Multi-Layer-Platine mindestens eine elektrisch leitende Lage, auf der keine LED-Chips aufgebracht sind.

Eine Multilayer-Platine ist so ausgeführt, dass die Höhe der einzelnen Lagen, eine Lage entspricht einer elektrisch leitenden Lage und einer elektrisch isolierenden Lage, der Höhe der zu verbauenden LED-Chips entspricht.

Eine Ausführungsform der Multilayer-Platine ist so gestaltet, dass die untersten LED-Chips mittig positioniert sind. Die darüber liegenden LED-Chips, welche auf darüber liegenden elektrisch leitenden Leiterbahnen aufgebracht sind, sind geometrisch so versetzt, dass das Licht der unterhalb liegenden LED-Chips ungehindert nach oben abgestrahlt werden kann und hierbei nicht durch darüber liegende Leiterbahnen oder Bauelemente insbesondere LED-Chips behindert wird, siehe auch Figur 2.

Bei einer elektrisch nicht leitenden Schicht, welche Wärme von der Metalllage der Multilayer-Platine auf den Kühlkörper leitet kann es sich auch um ein Halbleitermaterial, z.B. Silizium handeln.

Die unterste Lage der Multilayer-Platine besitzt eine Metalllage, über welche auch von unten ein Kühlkörper montierbar ist.

Über eine entsprechende Leiterbahnführung auf den verschiedenen elektrisch leitenden Lagen können mehrere LED-Chips elektrisch in Serie geschaltet werden.

Eine Form der Multilayer-Platine kann auch so ausgeführt werden, dass die LED-Chips der untersten Leiterbahn, auch BOT genannt, seitlich sitzen, wie in Figur 3 dargestellt.

Anstatt LED können auch andere Licht erzeugende Elemente verwendet werden, welche zur Lichterzeugung elektrisch zu betreiben sind.

Eine Ausführungsform kann aus der Verwendung von LEDs unterschiedlicher Helligkeit oder unterschiedlicher spektraler Abstrahlung bestehen.

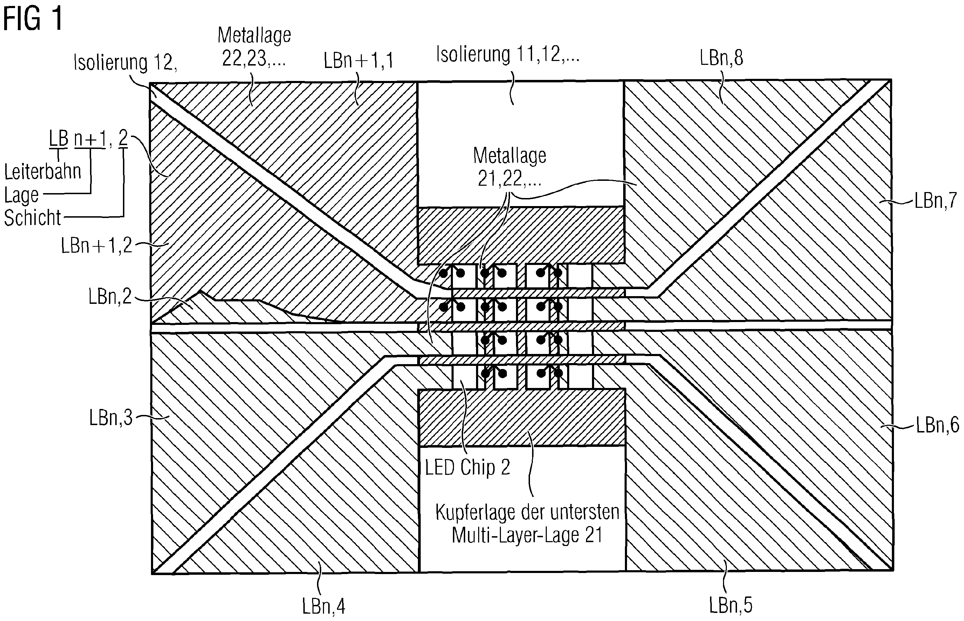

Figur 1 zeigt eine Aufsicht einer LED-Beleuchtungsanordnung, wobei entsprechend der Laufzahl n teilweise die Lage n und teilweise die Lage n+1 dargestellt sind. Bezüglich der Nummerierung mit i sind gegen den Uhrzeigersinn die Leiterbahnen i=1 - 8 verzeichnet.

Es ist wesentlich dass ein dreidimensionaler Aufbau des LED-Arrays unter Nutzung einer Multilayer-Platine dargestellt ist. Die Multilayer-Platine besitzt hierzu eine treppenförmige Struktur, so dass die offen liegenden elektrisch leitenden Lagen für die Positionierung der LEDs verwendbar sind. Dieses Prinzip erschließt viele Vorteile, ausgehend von der Packungsdichte bis hin zur Wärmeableitung.

Die vom LED-Chip auf die Metalllage abgegebene Wärme wird von der Metalllage direkt weitergeleitet. Die Metalllage wirkt auch wie eine Wärmekapazität, die die Verlustwärme aufnimmt und über die Fläche verteilt. Üblicherweise handelt es sich bei den Metalllagen von Multilayer-Platinen um den Werkstoff Kupfer oder einer Kupferlegierung. Auch andere leitende Werkstoffe anstelle von Kupfer können verwendet werden. Die Entwärmung bzw. Kühlung entlang der Metallschicht ist effektiver als der Wärmeübergang von Metall auf Luft oder Metall auf Wasser. Mit dickerer Metallbeschichtung werden die Wärmekapazität und der Wärmetransport zusätzlich günstig beeinflusst.

Durch die beschriebene Anordnung werden mehrere LEDs auf unterschiedlichen Höhenniveaus positioniert, so dass eine Anpassung der Strahlführungsoptik vorteilhaft ist.

## Patentansprüche

1. LED-Beleuchtungsanordnung, die Folgendes umfasst:
- mindestens eine Mehrlagenleiterplatte (1) auf der im Wesentlichen in eine Richtung strahlende LED-Chips (2) zur Bildung von Flächenstrahlern mit dreidimensionalem Aufbau auf mehreren stufenförmig ausgebildeten Metalllagen der Mehrlagenleiterplatte mit dazwischenliegenden Isolierlagen verteilt sind, derart, dass auf den jeweils offenliegenden Metalllagen die LED-Chips (2) positioniert sind, wobei die Mehrlagenleiterplatte eine außen aufgebrachte Kupferlage sowie VIAs oder Durchgänge umfasst,
- mindestens einen elektrischen Anschluss eines LED-Chips (2) an die Metalllage (n), auf der der LED-Chip aufgebracht ist, und
- mindestens einen weiteren direkten elektrischen Anschluss dieses LED-Chips (2) an eine darüber liegende Metalllage (n+1), auf der mindestens ein weiterer LED-Chip aufgebracht ist, so dass diese LED-Chips (2) gruppenweise in Reihe geschaltet sind,
wobei eine Wärmeleitung innerhalb der Mehrlagenleiterplatte über die VIAs oder Durchgänge geschieht, welche die Wärme von den einzelnen elektrisch leitenden Metalllagen auf die außen aufgebrachte Kupferlage abführen.

2. LED-Beleuchtungsanordnung nach Anspruch 1, bei der die elektrischen Anschlüsse durch Bonddrähte (4) ausgeführt sind.

3. LED-Beleuchtungsanordnung nach Anspruch 1 oder 2, bei der eine Mehrlagenleiterplatte mindestens eine elektrisch leitende Metalllage aufweist, auf der kein LED-Chip aufgebracht ist.

4. LED-Beleuchtungsanordnung nach einem der Ansprüche 1 bis 3, bei der eine Mehrlagenleiterplatte so ausgeführt ist, dass die Höhe einer Metalllage zusammen mit der Höhe einer Isolierlage ungefähr der Höhe eines LED-Chips entspricht.

5. LED-Beleuchtungsanordnung nach einem der Ansprüche 1 bis 4, bei der eine Mehrlagenleiterplatte so gestaltet ist, dass die untersten LED-Chips mittig positioniert sind und die darüber liegenden LED-Chips, welche auf darüber liegenden elektrisch leitenden Leiterbahnen aufgebracht sind, derart geometrisch versetzt sind, dass das Licht der unterhalb liegenden LED-Chips ungehindert nach außen abstrahlen kann.

6. LED-Beleuchtungsanordnung nach einem der Ansprüche 1 bis 5, bei der Verlustwärme von LEDs über Metalllagen abgeführt wird.

7. LED-Beleuchtungsanordnung nach Anspruch 6, bei der auf der untersten Metalllage der Mehrlagenleiterplatte eine zusätzliche Metalllage (20) aufgebracht ist, über welche von unten ein Kühlkörper montiert werden kann.

8. LED-Beleuchtungsanordnung nach einem der Ansprüche 1 bis 7, bei der LEDs unterschiedlicher Helligkeit und / oder unterschiedlicher spektraler Abstrahlung eingesetzt sind.

9. LED-Beleuchtungsanordnung nach einem der Ansprüche 1 bis 8, bei der mehrere Serienschaltungen von LED-Chips vorhanden sind.

## Claims

1. LED lighting arrangement comprising the following:
- at least one multilayer printed circuit board (1) on which are distributed LED chips (2) that emit substantially in one direction for forming surface emitters with three-dimensional construction on a plurality of metal layers formed in stepped fashion of the multilayer printed circuit board with insulating layers therebetween, in such a way that the LED chips (2) are positioned on the respectively exposed metal layers, wherein the multilayer printed circuit board comprises a copper layer applied on the exterior and also VIAs or passages,
- at least electrical connection of an LED chip (2) to the metal layer (n) on which the LED chip is applied, and
- at least one further of said LED chip (2) to an overlying metal layer (n+1) on which at least one further LED chip is applied, such that said LED chips (2) are connected in series in groups,
wherein heat conduction takes place within the multilayer printed circuit board by way of the VIAs or passages which dissipate the heat from the individual electrically conductive metal layers to the copper layer applied on the exterior.

2. LED lighting arrangement according to Claim 1, wherein the electrical connections are embodied by bond wires (4).

3. LED lighting arrangement according to Claim 1 or 2, wherein a multilayer printed circuit board has at least one electrically conductive metal layer on which no LED chip is applied.

4. LED lighting arrangement according to any of Claims 1 to 3, wherein a multilayer printed circuit board is embodied such that the height of a metal layer together with the height of an insulating layer corresponds approximately to the height of an LED chip.

5. LED lighting arrangement according to any of Claims 1 to 4, wherein a multilayer printed circuit board is fashioned such that the bottommost LED chips are positioned centrally and the overlying LED chips applied on overlying electrically conductive conductor tracks are geometrically offset in such a way that the light of the underlying LED chips can radiate towards the outside without being impeded.

6. LED lighting arrangement according to any of Claims 1 to 5, wherein heat loss from LEDs is dissipated by way of metal layers.

7. LED lighting arrangement according to Claim 6, wherein an additional metal layer (20) is applied on the bottommost metal layer of the multilayer printed circuit board, and a heat sink can be mounted over said additional metal layer from below.

8. LED lighting arrangement according to any of Claims 1 to 7, wherein LEDs with varying brightness and/or varying spectral emission are used.

9. LED lighting arrangement according to any of Claims 1 to 8, wherein a plurality of series connections of LED chips are present.

## Revendications

1. Dispositif d'éclairage à DEL, qui comprend ce qui suit :
- au moins une plaquette (1) à circuit imprimé à plusieurs couches, sur laquelle sont réparties sensiblement des puces (2) DEL émettant dans une direction, pour former des spots plats à structure tridimensionnelle sur plusieurs couches métalliques constituées en forme de palier de la plaquette à circuit imprimé à plusieurs couches, ayant des couches isolantes interposées, de manière à mettre les puces (2) DEL en position sur les couches métalliques respectivement à découvert, la plaquette à circuit imprimé à plusieurs couches comprenant une couche de cuivre déposée à l'extérieur, ainsi que des VIAs ou des traversées,
- au moins une borne électrique d'une puce (2) DEL sur la ou les couches (n) métalliques, sur laquelle la puce DEL est déposée et
- au moins une autre borne électrique directe de cette puce (2) DEL sur une couche (n+1) métallique se trouvant au-dessus, sur laquelle est déposée au moins une autre puce DEL, de sorte que ces puces (2) DEL sont montées en série groupe par groupe,
dans lequel une conduction de chaleur, au sein de la plaquette à circuit imprimé à plusieurs couches, se produit par les VIAs ou par les traversées, qui évacuent la chaleur des divers couches métalliques conductrices de l'électricité sur la couche de cuivre déposée à l'extérieur.

2. Agencement d'éclairage DEL suivant la revendication 1, dans lequel les bornes électriques sont réalisées par des fils (4) de liaison.

3. Agencement d'éclairage DEL suivant la revendication 1 ou 2, dans lequel une plaquette à circuit imprimé à plusieurs couches a au moins une couche métallique conductrice de l'électricité, sur laquelle il n'y a pas de puce DEL déposée.

4. Agencement d'éclairage DEL suivant l'une des revendications 1 à 3, dans lequel une plaquette à circuit imprimé à plusieurs couches est réalisée, de manière à ce que la hauteur d'une couche métallique, ensemble avec la hauteur d'une couche isolante, corresponde à peu près à la hauteur d'une puce DEL.

5. Agencement d'éclairage DEL suivant l'une des revendications 1 à 4, dans lequel une plaquette à circuit imprimé à plusieurs couches est conformée de manière à ce que les puces DEL les plus basses soient placées au milieu et que les couches DEL au-dessus, qui sont déposées sur des pistes conductrices de l'électricité se trouvant au-dessus, soient décalées géométriquement de manière à ce que la lumière des puces DEL se trouvant en dessous puissent rayonner vers l'extérieur sans obstacle.

6. Agencement d'éclairage DEL suivant l'une des revendications 1 à 5, dans lequel on évacue la chaleur perdue des DEL par les couches métalliques.

7. Agencement d'éclairage DEL suivant la revendication 6, dans lequel, sur la couche métallique la plus basse de la plaquette à circuit imprimé à plusieurs couches, est déposée une couche (20) métallique supplémentaire, par laquelle un puits de chaleur peut être monté par en dessous.

8. Agencement d'éclairage DEL suivant l'une des revendications 1 à 7, dans lequel on utilise des DEL de brillance différente et/ou de rayonnement spectral différent.

9. Agencement d'éclairage DEL suivant l'une des revendications 1 à 8, dans lequel il y a plusieurs circuits en série de puces DEL.
